Europäisches Patentamt

**European Patent Office** (11) Veröffentlichungsnummer: **0 063 347**

Office européen des brevets **B1**

(12) **EUROPÄISCHE PATENTSCHRIFT**

(45) Veröffentlichungstag der Patentschrift:
**24.07.85**

(51) Int. Cl.⁴: **H 05 K 3/20**

(21) Anmeldenummer: **82103101.0**

(22) Anmeldetag: **10.04.82**

(54) **Prägefolie zum Aufbringen von Leiterbahnen.**

(30) Priorität: **22.04.81 DE 3116078**

(43) Veröffentlichungstag der Anmeldung:
**27.10.82 Patentblatt 82/43**

(45) Bekanntmachung des Hinweises auf die Patenterteilung:
**24.07.85 Patentblatt 85/30**

(84) Benannte Vertragsstaaten:
**AT BE CH DE FR GB IT LI LU NL SE**

(56) Entgegenhaltungen:
**US - A - 2 776 235**
**US - A - 3 651 567**
**US - A - 3 703 603**

(73) Patentinhaber: **IVO Irion & Vosseler Zählerfabrik GmbH & Co., Dauchinger Strasse 58, D-7730 Villingen-Schwenningen (DE)**

(72) Erfinder: **Bauser, Herbert, Dr., Bärenseestrasse 8, D-7000 Stuttgart 80 (DE)**
Erfinder: **Kurz, Edmund, Neue Stuttgarter Strasse 30, D-7031 Magstadt (DE)**
Erfinder: **Schindler, Bernd. Dr., Arminstrasse 31, D-7000 Stuttgart 1 (DE)**
Erfinder: **Zerweck, Klaus, Dr., Schuberstrasse 42, D-7250 Leonberg (DE)**
Erfinder: **Bolch, Thomas, Schillerstrasse 12, D-7101 Abstatt (DE)**
Erfinder: **Haller, Andreas, Dauchinger Strasse 115, D-7730 Villingen-Schwenningen (DE)**
Erfinder: **Mager, Theo, Schabelweg 23, D-7737 Bad Dürrheim 1 (DE)**

(74) Vertreter: **Patentanwälte Dipl.-Ing. Klaus Westphal Dr. rer. nat. Bernd Mussgnug Dr. rer.nat. Otto Buchner, Waldstrasse 33, D-7730 VS-Villingen (DE)**

## Beschreibung

Die Erfindung betrifft eine Prägefolie zum Aufbringen von Leiterbahnen und/oder von Elementen elektrischer Komponenten auf z.B. isolierende Unterlagen der im Oberbegriff des Anspruchs 1 angegebenen Art.

Elektrische oder elektronische Schaltkreise werden vielfach auf Leiterplatten in Form gedruckter Verdrahtungen bzw. gedruckter Schaltungen aufgebracht. Die üblichen Herstellungsverfahren sind material- und arbeitsaufwendig und erfordern komplizierte Einrichtungen. Bei der Subtraktiv- und Durchmetallisierungstechnik sind z.B. auf kupferkaschierte, bei der Additiv- und Semiadditivtechnik auf mit sensibilisatordotierte Haftvermittler beschichtete Basismaterialien Leitungsbilder mit Hilfe von Siebdruck oder Fotodruck aufzubringen, worauf die Leiterplatten – je nach angewandter Technik – nach vorausgegangenem chemischem oder galvanischem Verkupfern und galvanischem Nachverstärken bzw. galvanischem Verzinnen geätzt werden. Zwischen diesen wichtigsten Verfahrensschritten sind weitere Verfahrensschritte notwendig wie Reinigung, Entfernen der Leitungsmaske, Trocknen, Zwischenkontrollieren und dgl. Während die rein mechanischen Teile der Geräte, z.B. Gehäuseteile, mechanisch bewegliche Teile, Stützen und dgl. Konstruktionselemente, mit Verfahren wie Spritzguss, Stanzen, Ziehen usw., hergestellt werden können, die einen hohen Ausstoss pro Zeiteinheit ermöglichen, erfordert das Herstellen der Leiterplatten nach den oben erwähnten «nassen» Verfahren einen unverhältnismässig hohen Zeit- und Arbeitsaufwand. Es sind deshalb schon verschiedene «trockene» Verfahren vorgeschlagen worden, bei welchen Leiterbahnen von einem in einer Rolle vorliegenden Material direkt auf eine Unterlage aufgebracht werden. Diese Verfahren lassen sich in drei Gruppen einteilen:

Die erste Gruppe umfasst Stanzverfahren, bei welchen aus einer selbsttragenden leitenden Folie, die auf einer Unterlage aufliegt, Leiterbahnen ausgestanzt und ggf. im gleichen Arbeitsgang auf der Unterlage festgeklebt werden. Gemeinsame Nachteile dieser Verfahren sind:

1. Die Stanzwerkzeuge sind relativ teuer.
2. Das Entfernen der restlichen, nicht für die Leiterbahnen verwendeten leitenden Folien von der Unterlage ist besonders bei nahezu geschlossenen Leiterbahnen schwierig oder doch umständlich.
3. Es ist schwierig, sehr schmale Leiterbahnen mit engen Abständen aufzubringen.

Die zweite Gruppe betrifft Verfahren, bei denen die Leiterbahnen mit dem eingangs erwähnten nassen Verfahren vorgefertigt, auf ein Trägerband gebracht und von diesem dann auf die Unterlage übertragen werden. Hierbei ist von Nachteil, dass für die Vorfertigung der Leiterbahnen die aufwendigen Schritte der eingangs erwähnten «Techniken» angewandt werden müssen. Ausserdem können sich die vorgefertigten Leiterbahnen beim Aufbringen auf die Unterlage verziehen.

Bei der dritten Gruppe werden die Leiterbahnen aus einer auf einem Trägerband aufgebrachten Kupferfolie ausgeschnitten und nach dem Ausschneiden vom Trägerband auf die Unterlage übertragen. Von der auf die Unterlage aufgetragenen Kupferfolie wird dann das Trägerband abgezogen. Nachteilig ist hier das umständliche und nicht sehr präzise Ausschneiden vor dem Aufbringen der Leiterbahnen.

Ausser den genannten, für das Herstellen gedruckter Schaltungen gedachten Verfahren gibt es noch das Heissprägeverfahren, mit dem sich zwar dünne Filme – auch aus im Prinzip leitenden Materialien – in nahezu beliebiger Form auf Unterlagen bringen lassen, das aber zum Herstellen von Leiterbahnen für gedruckte Schaltungen bisher nicht eingesetzt werden konnte. Die Schichten, die mit konventionellen Heissprägefolien in verschiedenen Mustern aufgeprägt werden können, sind nämlich mit Schichtdicken bis zu maximal ca. 100 nm für Leiterbahnen um ca. zwei Grössenordnungen zu dünn. Die geringe Schichtdicke hat dabei nicht nur zur Folge, dass der elektrische Widerstand (z.B. von Kupfer) viel zu hoch ist, sondern auch, dass der Wert des elektrischen Widerstandes infolge mangelnder Schichtqualität und infolge von Eindiffusion des Haftvermittlers in die Schicht nicht reproduzierbar ist, also in der Fertigung unzulässig grossen Toleranzen unterworfen ist. Ein weiterer Nachteil der mit konventionellen Heissprägefolien aufgebrachten metallischen Schichten ist deren ungenügende Verzinnbarkeit bzw. Lötbarkeit, die teils auf die geringe Schichtdicke, teils auf ihre zum Löten ungeeignete Oberfläche zurückzuführen ist. Es ist zwar möglich, die auf die Unterlage aufgeprägten dünnen Leiterbilder galvanisch nachzuverstärken. Dies würde jedoch einerseits den Vorteil des raschen, unkomplizierten Herstellens der Leiterbahnen zunichte machen, da es sich hierbei ja um Galvanisieren von Stückware mit umständlicher Kontaktierung handelte. Zum anderen würde das Galvanikbad auch durch das teils in die Schichten eindiffundierte Material der Haftschicht verunreinigt. Ferner würde die galvanische Nachverstärkung infolge des nicht reproduzierbaren elektrischen Widerstandes ungleichmässig. Schliesslich würden Haftprobleme und Beständigkeitsprobleme auftreten. Andererseits würde das Heissprägeverfahren grosse Vorteile bieten, wenn es gelänge, Leiterbahnen der erforderlichen Dicke mit diesem aufzubringen. Im Gegensatz zu den oben aufgeführten trockenen Verfahren könnte das Befestigen der Leiterbahnen auf der Unterlage mit dem Abscheren und Entfernen der Restfolie in einem einzigen Arbeitsgang erfolgen. Die erforderlichen Prägewerkzeuge wären billiger als vergleichbare Stanzwerkzeuge. Ausserdem gestattet das Heissprägeverfahren grundsätzlich, Muster auf ebene und gekrümmte Teile aufzuprägen. So können z.B. Ziffern auf die Mantelfläche von Kunststoffscheiben für Zähler-

anzeigegeräte geprägt werden. Ein Heisspräge-verfahren besitzt grundsätzlich die o.g. Vorteile der trockenen Verfahren gegenüber den eingangs beschriebenen «nassen» Techniken. Ausserdem können mit diesem Verdrahtungs- oder Schaltungsteile auf ohnehin vorhandenen isolierenden Teilen, z.B. auf Gehäuseteilen, untergebracht werden, so dass auf besondere Leiterplatten für die Verdrahtung bzw. weitere Schaltungsteile verzichtet werden kann. Ferner wäre häufig eine Leiterplatte in einem Gerät leichter und kompakter unterzubringen, wenn sie komplexere Krümmungen aufweisen würde, als mit den heutigen Techniken möglich ist.

Aus der US-A3 651 567 ist eine Prägefolie bekannt, die aus einem Polyesterfilm als Trägerband und einer Palladiumpulver mit Binder enthaltenden leitfähigen Schicht besteht. Mittels einer derartigen Prägefolie können unter Verwendung eines Prägestempels unter Druck und Wärmeeinwirkung Leiterbahnen oder auch Elemente von elektrischen Komponenten, z.B. Elektroden von Kondesatoren, auf eine isolierende Unterlage übertragen werden, die hier aus Barium-Titanat besteht und mit dieser durch Einbrennen fest zu verbinden ist. Auch dieses Verfahren hat den entscheidenden Nachteil, dass die aufgebrachten Leiterbahnen wegen der zwangsläufig auftretenden Dickentoleranzen keine reproduzierbare elektrische Leitfähigkeit besitzen.

So liegt der Erfindung die Aufgabe zugrunde, eine Prägefolie des im Oberbegriff des Anspruchs 1 genannten Aufbaus, wie sie zur Herstellung sehr dünner Dekorationsschichten an sich bekannt ist, zu schaffen, welche einerseits gleichbleibende, eng tolerierte Schichtstärke ausreichender elektrischer Leitfähigkeit besitzt und die bei genügender Festigkeit die für das Trennen nach dem Prägevorgang ausreichende geringe Scherfestigkeit besitzt.

Nur eine derartige Prägefolie ist zur Herstellung und zum Aufbringen von elektrischen Leiterbahnen bzw. Elementen elektrischer Komponenten auf eine isolierende Unterlage geeignet, wobei die Unterlage ihrerseits in einem Gerät ein ohnehin notwendiges, mechanisch funktionelles Teil ist oder wobei die Unterlage in eine für eine kompakte Bauweise geeignete Form gebracht werden kann.

Gelöst wird diese Aufgabe mit einer Prägefolie der genannten Art, deren elektrisch leitende Schicht die im Kennzeichen des Anspruchs 1 angegebenen Merkmale besitzt.

Mit der erfindungsgemässen Prägefolie können beliebige Muster aus leitenden Schichten von bei Leiterplatten bzw. gedruckten Schaltungen üblichen Schichtdicken mit Stärken zwischen 10 bis 35 μm aufgeprägt werden, die manuell oder maschinell löt- bzw. verzinnbar sind und deren elektrischer Leitwert reproduzierbar ist.

Eine weitere Variante dieser Prägefolie ist mit Anspruch 2 angegeben.

Weitere Ausgestaltungen der Prägefolie sind Gegenstand der Ansprüche 3 bis 12.

Bevorzugte Ausführungsbeispiele der erfindungsgemässen Prägefolie sind mit den Fig. 1 bis 5 veranschaulicht, die nachstehend im einzelnen erläutert sind.

In der Zeichnung zeigen:

Fig. 1: Vergrösserter Schnitt einer bisher üblichen Heissprägefolie in nicht massstäblicher Darstellung mit einem Prägestempel-Klischee in abgebrochener Seitenansicht,

Fig. 2: Schnittdarstellung gemäss Fig. 1 nach erfolgtem Heissprägen bei abgehobener Restfolie und entferntem Prägestempel-Klischee,

Fig. 3: vergrösserter Schnitt einer erfindungsgemässen Heissprägefolie entsprechend den Darstellungen gemäss Fig. 1 und Fig. 2 und

Fig. 4 und 5: vergrösserte Seitenansichten der elektrisch leitenden Schicht zur Veranschaulichung des kristallinen Gefüges einer erfindungsgemässen Prägefolie.

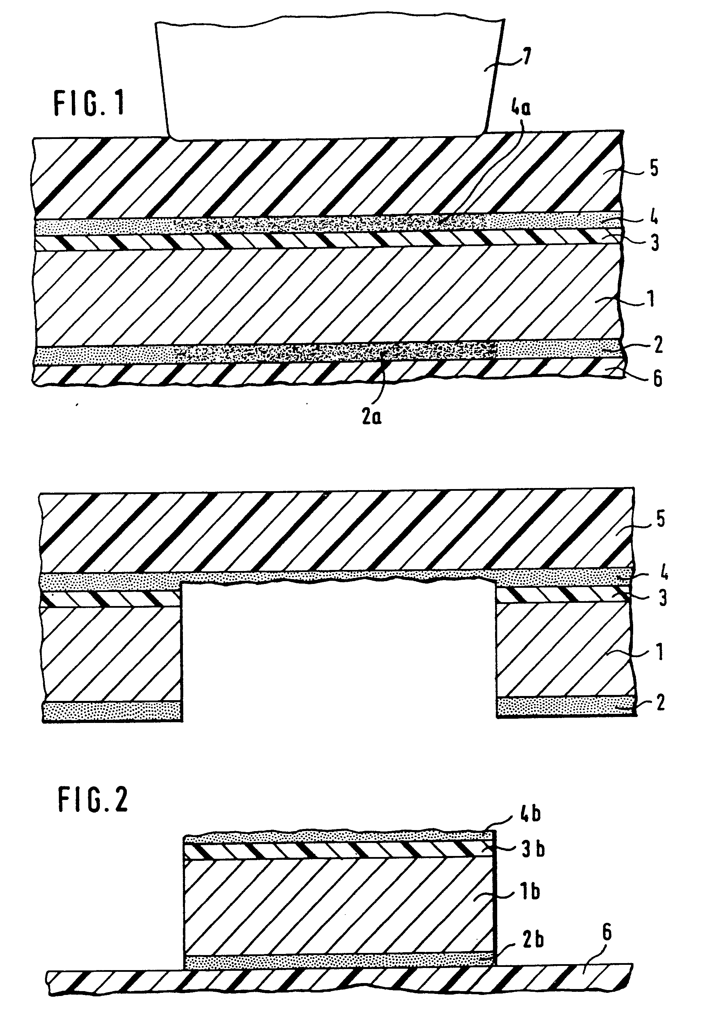

In Fig. 1 ist beispielsweise der Aufbau einer bisher üblichen Heissprägefolie in nicht massstäblicher Darstellung skizziert. Solche Heissprägefolien bestehen aus mehreren Lagen verschiedener Materialien: Eine oder mehrere Lagen Schmelzkleber 2 (Dicke z.B. 3 μm), funktionelle Schicht 1 (Dicke z.B. ca. 50 nm), die bei herkömmlichen Folien im allgemeinen eine dekorative oder graphische Funktion übernimmt, aber auch als dünne Metallschicht bis zu einem gewissen – für Leiterbahnen nicht ausreichenden – Grad elektrisch leitend sein kann, Schutzschicht 3 (Dicke z.B. 1,5 μm), Trennschicht 4 (Dicke z.B. ca. 100 nm) und Trägerband 5 (z.B. Polyester, Dicke z.B. ca. 12 μm). In Fig. 1 ist die funktionelle Schicht 1 im Vergleich zum Trägerband 5 in besonders massstabwidriger Weise dick gezeichnet. Für die noch zu beschreibende erfindungsgemässe Heissprägefolie stimmt das skizzierte Grössenverhältnis der Schichten 1 und 5 besser.

Zum Aufbringen der funktionellen Schicht 1 wird nach bekanntem Verfahren die Heissprägefolie in Form eines Bandes auf eine Unterlage 6 entsprechend Fig. 1 aufgelegt, und mittels eines auf einem geheizten Prägestempel gebrachten Klischees 7 an die Unterlage angedrückt. Dabei bewirkt der durch Druck und Hitze des Klischees aktivierte Teil 2a des Schmelzklebers 2 ein Anhaften der funktionellen Schicht 1 in Form des auf dem Klischee vorhandenen Musters am Werkstück und der durch das Klischee aktivierte Teil 4a der Trennschicht 4 ermöglicht das Ablösen der funktionellen Schicht 1 mit der Schutzschicht 3 vom Trägerband 5. Nach dem Abheben des Klischees 7 und der restlichen Heissprägefolie von der Unterlage 6 bleibt deshalb der aktivierte Teil 1b der funkionellen Schicht 1, der Teil 3b der Schutzschicht 3 und evtl. Reste 4b der Trennschicht 4 mit dem sich wieder verfestigenden Teil 2b des Schmelzklebers 2 fest haftend auf der Unterlage 6 zurück.

Wenn bei einer derartigen Heissprägefolie die funktionelle Schicht 1 durch eine übliche Kupferfolie, z.B. der Dicke 10 μm, deren elektrischer

Leitwert für viele Anwendungen ausreichen würde, gebildet wird, so liessen sich damit noch keine Leiterbahnen aufprägen, da eine scharfrandige Trennung der Leiterbahnen entsprechend dem Muster des Klischees nicht möglich wäre. Vielmehr würde die Kupferfolie in unregelmässiger, evtl. fetzenartiger Form teils an der Unterlage, teils am Trägerband oder auch gänzlich am einen oder anderen anhaften.

Bei der erfindungsgemässen Prägefolie besteht dagegen die funktionelle Schicht 1 aus einem Material, dessen Scherfestigkeit aufgrund seines kristallinen Gefüges und seiner Zusammensetzung einen so kleinen Wert hat, dass Leiterbahnen oder auch integrierte elektrische Bauelemente mit ähnlicher Dicke von z.B. 10 bis 35 µm wie bei üblichen Leiterplatten bzw. gedruckten Schaltungen prägbar sind, und bei dem der nichtaktivierte Teil der leitenden Schicht nach dem Prägen abhebbar und mittels des Trägerbandes unter scharfrandiger Trennung von dem geprägten Teil abreissbar ist. Bei einem Ausführungsbeispiel der erfindungsgemässen Prägefolie sind für die funktionelle Schicht 1 z.B. kristalline Gefüge aufweisende Kupferfolien ausgewählt, deren Scherfestigkeit zwischen 10 und 50 N/mm² liegt und welche ausreichende Duktilität für die Verarbeitung von der Rolle besitzen.

Eine weitere Eigenschaft der erfindungsgemässen Prägefolie ist, dass sich die beispielsweise aus Kupfer gebildete funktionelle Schicht 1 gut von Hand oder mit der Maschine mit konventionellen oder nach Wahl speziellen Löt-zinn-Typen, ohne Abheben der Leiterbahn von der Unterlage, ohne Blasenbildung und ohne Benetzungsprobleme löten und verzinnen lässt. Trotz der ungewöhnlich leichten Abscherbarkeit der funktionellen Schicht liegen bei der erfindungsgemäss aufgebauten Prägefolie die gemessenen Werte für die elektrische Leitfähigkeit z.B. bei einer aus Kupfer gebildeten funktionellen Schicht bei 25 bis 45 m/Ohm mm² und damit nur geringfügig unter dem Leitfähigkeitswert für Elektrolytkupfer (57 m/Ohm mm²).

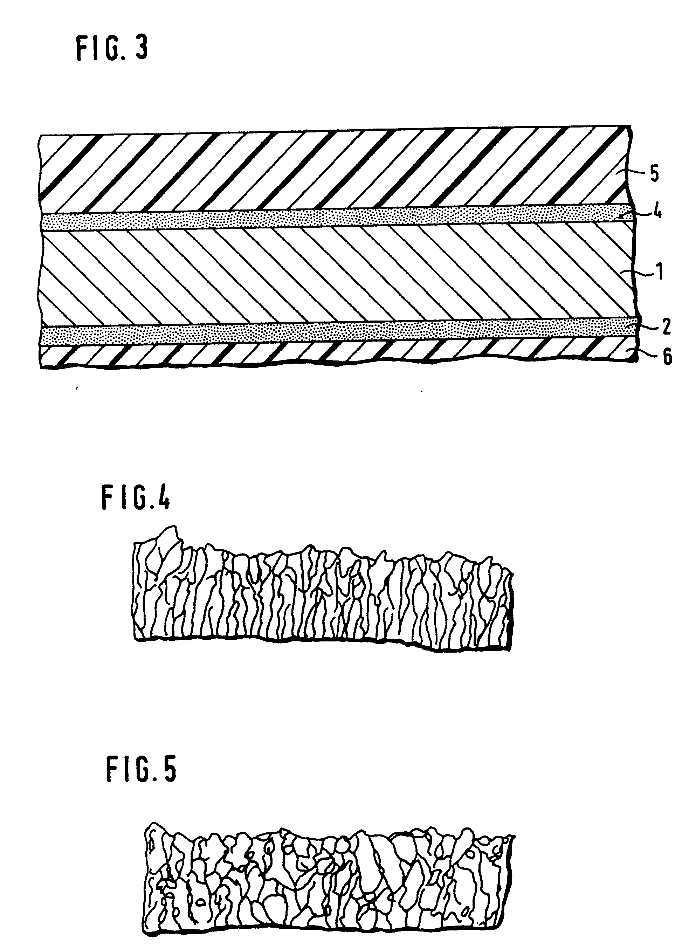

Die für die erfindungsgemässe Prägefolie benutzte funktionelle Schicht, z.B. aus Kupfer, hat ein kristallines Gefüge, das sich in idealisierender Vereinfachung als faserig oder faserig-körnig aufgebaut beschreiben lässt, wobei die faserigen Strukturen annähernd senkrecht zur Schichtebene ausgerichtet sind. Solche kristallinen Gefüge sind in Fig. 4 und Fig. 5 dargestellt. Die Faserdurchmesser betragen z.B. 0,5 bis 2 µm. In für die funktionelle Schicht 1 der erfindungsgemässen Prägefolie verwendeten Kupfersorten sind Spuren von Kohlenstoff, Stickstoff und Schwefel vorhanden.

Besteht die gedruckte Schaltung nicht nur aus Leiterbahnen im Sinne einer gedruckten Verdrahtung, sondern müssen neben Kupferbahnen auch Muster aus anderen Metallen oder Metallverbindungen auf die Unterlage aufgebracht werden, so können zwei oder mehrere Prägefolien mit verschiedenen Metallen als funktionelle Schicht 1 eingesetzt werden, die nacheinander mit verschiedenen Klischees nach dem oben erläuterten Prägeverfahren verarbeitet werden.

Der grundsätzliche Schichtaufbau der erfindungsgemässen Prägefolie ist weitgehend analog zu dem der bekannten Heissprägefolien. Deshalb dienen die Fig. 1 und 2 auch der Erläuterung der Erfindung. Die funktionelle Schicht 1 ist im allgemeinen mit einer Schutzschicht 3 (Fig. 1) überzogen. Bei der erfindungsgemässen Prägefolie erfüllt die Schutzschicht die Funktion eines das Löten erleichternden Flussmittels. In dieser Ausführungsform besteht sie z.B. aus einem Lötlack. In einer anderen Ausführungsform wird die Funktion des Flussmittels von der darüberliegenden Trennschicht 4 mit übernommen, so dass die Schutzschicht entfällt (Fig. 3). In diesem Fall enthält die Trennschicht 4 oder – bei Aufbau der Trennschicht 4 aus mehreren Einzelschichten – die der funktionellen Schicht nächste Einzelschicht der Trennschicht ein das Löten erleichterndes Flussmittel, z.B. ein Gemisch aus Terpenen.

Gemäss einer Ausführungsform besteht die Trennschicht 4 aus einem Schmelzkleber, der sich gegenüber dem für die Haftschicht 2 (s.u.) verwendeten Schmelzkleber unterscheidet: Der Festpunkt des für die Trennschicht 4 verwendeten Schmelzklebers liegt unterhalb des Festpunkts des für die Haftschicht 2 verwendeten Schmelzklebers und seine Erstarrungsgeschwindigkeit ist merklich kleiner (z.B. zehnmal kleiner) als diejenige des für die Haftschicht verwendeten Schmelzklebers. Ein typischer Wert für den Festpunkt des für die Trennschicht 4 verwendeten Schmelzklebers ist 100°C, ein typischer Wert für die Erstarrungskonstante ist $1\,s^{-1}$. (Zum Vergleich typische Werte für die Haftschicht 2: Festpunkt 180°C, Erstarrungskonstante $10\,s^{-1}$). Der Schmelzkleber für die Trennschicht 4 besteht in einer Ausführungsform aus einer Mischung mit drei Hauptkomponenten, nämlich erstens einem Elastomer, zweitens einem Thermoplast, drittens einem Gemisch aus langkettigen Carbonsäuren bzw. Carbonsäureestern oder einem Gemisch aus Terpenen oder einer Mischung aus beiden Gemischen.

In einer weiteren Ausgestaltung der Erfindung besteht die Trennschicht aus einer Substanz oder einem Substanzgemisch, das bis zu einer Grenztemperatur, die deutlich (z.B. um 50°C) unter der Prägetemperatur liegt, eine gute Haftung zwischen funktioneller Schicht 1 und Trägerband 5 bewirkt, bei Überschreiten dieser Grenztemperatur sich jedoch in der Weise chemisch umwandelt, dass sie ihre Klebefestigkeit verliert.

Die Substanz bzw. das Substanzgemisch der Trennschicht 4 kann von solcher Art sein, dass die chemische Umwandlung unter Gasentwicklung vor sich geht, wodurch die bei Erhitzung erwünschte Trennung der funktionellen Schicht 1 vom Trägerband 5 erleichtert wird.

In einer anderen Ausführungsform der erfindungsgemässen Prägefolie besteht die Trennschicht 4 aus einem Kleber, dessen Haftfestigkeit durch Eintrag eines Lösungsmittels beim Prägevorgang aufgehoben bzw. vermindert wird. Das Lösungsmittel wird z.B. mit Hilfe von Mikrokapseln eingetragen. Die Mikrokapseln, die das Lösungsmittel enthalten, sind Bestandteile des Klebers (bzw. der Trennschicht 4) und geben beim Erhitzen auf die Prägetemperatur und unter dem Prägedruck das Lösungsmittel frei.

In einer besonderen Ausführungsform geben die Mikrokapseln das Lösungsmittel allein unter dem Einfluss des Prägedrucks frei (ohne Erhitzung). Bei dieser Ausführungsform wird auch die Haftschicht 2 allein durch Druck aktiviert. Sie besteht dann z.B. aus einer zunächst nicht bzw. nicht ausreichend klebenden Substanz, in welche ebenfalls Mikrokapseln eingebettet sind. Diese Mikrokapseln enthalten eine die Klebefähigkeit der Haftschicht aktivierende Flüssigkeit, z.B. ein Lösungsmittel, welche unter dem Einfluss des Prägedrucks freigegeben wird. Diese Ausführungsform könnte sinnvollerweise als Kaltprägefolie bezeichnet werden.

In einer weiteren Ausführungsform befinden sich im Grundmaterial der Trennschicht 4 Mikrokapseln, die eine reaktionsfähige Substanz enthalten, welche beim Prägevorgang frei wird und mit dem Grundmaterial der Trennschicht mittels einer chemischen Umwandlung derart reagiert, dass die durch das Grundmaterial bewirkte Haftung zwischen der funktionellen Schicht 1 und Trägerband 5 aufgehoben bzw. in ausreichendem Mass vermindert wird (d.h., dass die Haftfestigkeit zwischen Trägerband 5 und funktioneller Schicht 1 geringer ist als zwischen funktioneller Schicht 1 und Unterlage 6). Eine Verstärkung des gewünschten Effekts kann durch mehrere Arten von Mikrokapseln (d.h. mit Lösungsmittel und/ oder mit reaktionsfähigen Substanzen gefüllten Mikrokapseln) in der Trennschicht 4 erreicht werden.

Für das Trägerband 5 dient in bekannter Weise eine Kunststoff-Folie, z.B. aus einem Polyester wie Polyäthylenterephthalat, die entweder nach Beschichten mit der Trennschicht 4 oder nach dem Beschichten der funktionellen Schicht 1 mit dem Material der Trennschicht 4 zu einem festen Verbund zusammengeführt wird.

Vor oder nach dem Verbinden von funktioneller Schicht 1 und Trägerband 5 mittels der Trennschicht 4 wird die funktionelle Schicht 1 auf der der Trennschicht 4 abgewandten Seite mit einer oder mehreren Lagen einer Haftschicht 2 beschichtet. Die Haftschicht 2 besteht aus einem oder mehreren Schmelzklebern. Für diejenige Ausführungsform der erfindungsgemässen Heissprägefolie, bei der auch die Trennschicht 4 aus einem Schmelzkleber besteht, wurde bereits oben angegeben, wie die Schmelzkleber von Haftschicht 2 und Trennschicht 4 aufeinander abgestimmt sein müssen. Der Schmelzkleber ist im allgemeinen elektrisch nicht leitend.

Als Beispiel für einen Schmelzkleber für die Haftschicht 2 wurde z.B. ein Kleber eingesetzt, der unter dem Warenzeichen Wikolin 464/3 bekannt ist.

Es wurde bereits darauf hingewiesen, dass in einer anderen Ausführungsform die Haftschicht 2 aus einer zunächst nicht oder nicht ausreichend klebefähigen Substanz besteht, in welche Mikrokapseln eingebettet sind. Diese Mikrokapseln enthalten eine Flüssigkeit, welche bei Freiwerden beim Prägevorgang (Einwirkung von Druck allein oder auch von Druck und Temperatur) die Klebefähigkeit der Haftschicht 2 aktiviert. Diese aktivierende Flüssigkeit kann entweder ein Lösungsmittel sein oder eine mit der Substanz der Haftschicht im Sinne eines Zweikomponentenklebers reagierende Flüssigkeit.

In einer weiteren Ausführungsform besteht die Haftschicht 2 aus einer reaktionsfähigen Substanz, die während des Prägevorgangs sowohl mit der Oberfläche der Unterlage 6 als auch mit der Oberfläche der funktionellen Schicht 1 chemisch reagiert und so zu einem festen Verbund zwischen Unterlage 6 und funktioneller Schicht 1 führt. In einer besonderen Ausführungsform wird die reaktionsfähige Substanz erst bei der Zuführung der Prägefolie zum Prägewerkzeug auf die Kupferschicht aufgetragen.

Die Beschichtung der funktionellen Schicht 1 mit der Trennschicht 4 und mit der Haftschicht 2 bzw. die Beschichtung des Trägerbandes 5 mit der Trennschicht 4 geschieht mittels an sich bekannter Beschichtungsverfahren wie Spritzen, Giessbeschichten, Extrusionsbeschichten, Bestreichen, Tauchen o.ä. Eine vereinfachte Ausführungsform der erfindungsgemässen Prägefolie lässt sich dadurch herstellen, dass auf die funktionelle Schicht 1 eine oder mehrere Lagen von Schmelzklebern aufgebracht werden, wobei auf Trägerband 5, Trennschicht 4 und gegebenenfalls auch Schutzschicht 3 verzichtet wird. In diesem Fall ist die funktionelle Schicht 1 selbsttragend. Damit lassen sich gute Leiterbahnen, z.B. aus Kupfer, aufprägen, jedoch muss bei komplizierten Mustern von Leiterbahnen wegen des fehlenden Trägerbandes 5 der nicht aufgeprägte Teil der funktionellen Schicht 1 durch eine Wisch- oder Bürstvorrichtung entfernt werden. Das scharfrandige Abtrennen des geprägten vom nichtgeprägten Teil der funktionellen Schicht geschieht – im Gegensatz zum Stanzen – beim Abheben bzw. Abwischen oder Abbürsten des nicht geprägten Teils der funktionellen Schicht 1.

Bei den erfindungsgemässen Prägefolien können für die funktionelle Schicht 1 unterschiedlich elektrisch oder elektronisch wirksame Materialien verwendet werden, so dass sich Schichten mit unterschiedlicher elektrischer Funktion aufprägen lassen, wie Leiterbahnen aus Metallen (Kupfer, Silber o.ä.), Widerstandsbahnen (andere Metalle oder auch Metalloxide), Halbleiterelemente, Photoleiter bzw. Photodioden (Anwendung z.B. in Belichtungsmessern) u.a.

**Patentansprüche**

1. Prägefolie zum Aufbringen von Leiterbahnen und/oder Elementen von elektrischen Komponenten auf z.B. isolierende Unterlagen, welche mindestens aus einer Haftschicht, einer elektrisch leitenden Schicht, einer Trennschicht und einem Trägerband besteht, und aus welcher mit Hilfe eines Prägestempels die Leiterbahnen unter Aktivierung von Trennschicht und Haftschicht prägbar sind, dadurch gekennzeichnet, dass die elektrisch leitende Schicht (1) aus einem Material gebildet ist, dessen Scherfestigkeit aufgrund seines kristallinen Gefüges und seiner Zusammensetzung einen so kleinen Wert hat, dass die geprägten Leiterbahnen oder auch integrierte elektrische Bauelemente unter scharfrandiger Trennung von dem nicht geprägten Teil der leitenden Schicht (1) abreissbar sind.

2. Prägefolie zum Aufbringen von Leiterbahnen und/oder Elementen von elektrischen Komponenten auf z.B. isolierende Unterlagen, welche aus einer elektrisch leitenden Schicht und einer Haftschicht besteht und aus der mit Hilfe eines Prägestempels die Leiterbahnen unter Aktivierung der Haftschicht prägbar sind, dadurch gekennzeichnet, dass die elektrisch leitende Schicht als selbsttragende Folie aus einem Material gebildet ist, dessen Scherfestigkeit aufgrund seines kristallinen Gefüges und seiner Zusammensetzung einen so kleinen Wert hat, dass die geprägten Leiterbahnen oder auch integrierte elektrische Bauelemente unter scharfrandiger Trennung von dem nicht geprägten Teil der leitenden Schicht abreissbar sind.

3. Prägefolie nach Anspruch 1 oder 2, dadurch gekennzeichnet, dass die Leitfähigkeit der leitenden Schicht der bei bekannten Leiterplatten bzw. gedruckten Schaltungen üblichen entspricht (z.B. bei Kupfer ca. 50 m/Ohm mm²).

4. Prägefolie nach Anspruch 1 oder 2, dadurch gekennzeichnet, dass die leitende Schicht (1) ein senkrecht zur Schichtebene faseriges oder faserig-körniges Kristallgefüge aufweist.

5. Prägefolie nach Anspruch 1 oder 2, dadurch gekennzeichnet, dass in die leitende Schicht (1) zur Beeinflussung der Scherfestigkeit Kohlenstoff, Stickstoff und Schwefel enthaltende Dotierungsstoffe eingelagert sind.

6. Prägefolie nach Anspruch 1, dadurch gekennzeichnet, dass entweder die Trennschicht (4) oder – bei Aufbau der Trennschicht aus mehreren Einzelschichten – die der leitenden Schicht nächste Einzelschicht der Trennschicht oder eine zwischen der leitenden Schicht (1) und der Trennschicht (4) liegende Schutzschicht (3) das Löten erleichternde Flussmittel enthält.

7. Prägefolie nach Anspruch 1, dadurch gekennzeichnet, dass Haftschicht (1) und Trennschicht (4) aus unterschiedlichen Schmelzklebern bestehen, dass der Festpunkt des Schmelzklebers für die Trennschicht (4) unterhalb des Festpunktes des für die Haftschicht (2) verwendeten Schmelzklebers liegt und die Erstarrungsgeschwindigkeit des Schmelzklebers für die Trennschicht (4) merklich kleiner ist als diejenige des für die Haftschicht (2) verwendeten Schmelzklebers.

8. Prägefolie nach Anspruch 1, dadurch gekennzeichnet, dass die Trennschicht (4) aus Substanzen besteht, die sich bei Erreichen einer bestimmten Temperatur, die deutlich (z.B. um 50°C) unter der Prägetemperatur liegt, bei der das Aufbringen der Leiterbahnen bzw. der elektrischen Bauelemente auf die Unterlage erfolgt, in der Weise chemisch umwandeln, ggf. unter Gasentwicklung, dass sie ihre Klebefestigkeit verlieren.

9. Prägefolie nach Anspruch 1, dadurch gekennzeichnet, dass die Trennschicht (4) aus einem Kleber besteht, dessen Haftfestigkeit durch Eintragen eines Lösungsmittels beim Prägevorgang aufgehoben bzw. verringert wird, und dass das Lösungsmittel mit Hilfe von Mikrokapseln eingetragen wird derart, dass die Mikrokapseln, die das Lösungsmittel enthalten, mit dem Kleber der Trennschicht (4) vermischt sind und beim Prägevorgang das Lösungsmittel freigeben.

10. Prägefolie nach Anspruch 1, dadurch gekennzeichnet, dass die Trennschicht (4) aus einem Kleber besteht, dessen Haftfestigkeit durch chemische Reaktion mit einem Reagenz aufgehoben bzw. reduziert wird, das beim Prägevorgang mit Hilfe von in die Trennschicht (4) eingebetteten Mikrokapseln freigesetzt wird.

11. Prägefolie nach Anspruch 1 oder 2, dadurch gekennzeichnet, dass die Haftschicht (2) aus einer Substanz besteht, die durch ein Lösungsmittel oder ein chemisches Reagenz, das beim Prägevorgang mit Hilfe von in die Haftschicht (2) eingebetteten Mikrokapseln freigesetzt wird, in einen Kleber umgewandelt wird.

12. Prägefolie nach Anspruch 1 oder 2, dadurch gekennzeichnet, dass die Haftschicht (2) aus einem – ggf. unmittelbar vor dem Prägevorgang auf die Oberfläche der leitenden Schicht aufgetragenen – Reagenz besteht, das während des Prägevorgangs eine chemische Verbindung mit der Oberfläche der Unterlage (6) und der Oberfläche der leitenden Schicht (1) eingeht.

**Claims**

1. Embossing foil for the application of conducting tracks and/or elements of electrical components on to, for example, insulating bases, which consist at least of an adhesion layer, an electrically conductive layer, a release layer and a carrier strip, and from which the conducting tracks can be embossed with the aid of an embossing punch trough activation of the release layer and adhesion layer, characterised in that the electrically conductive layer (1) is formed of a material whose shear strength has, due to its crystalline structure and its composition, so small a value that the embossed conducting tracks or else integrated electrical components can be torn off with sharp-edged separation from the non-embossed part of the conductive layer (1).

2. Embossing foil for the application of conducting tracks and/or elements of electrical components on to, for example, insulating bases, which consist of an electrically conductive layer and an adhesion layer and from which the conducting tracks can be embossed with the aid of an embossing punch through activation of the adhesion layer, characterised in that the electrically conductive layer is formed, as self-supporting foil, of a material whose shear strength has, due to its crystalline structure and its composition, so small a value that the embossed conducting tracks or else integrated electrical components can be torn off with sharp-edged separation from the non-embossed part of the conductive layer.

3. Embossing foil according to Claim 1 or 2, characterised in that the conductivity of the conductive layer corresponds to that which is customary in the case of known conductor boards or printed circuits (e.g. in the case of copper, approximately 50 m/ohm mm²).

4. Embossing foil according to Claim 1 or 2, characterised in that the conductive layer (1) has a fibrous or fibrous-granular crystal structure perpendicular to the layer plane.

5. Embossing foil according to Claim 1 or 2, characterised in that doping substances containing carbon, nitrogen and sulphur for influencing the shear strength are incorporated in the conductive layer. (1).

6. Embossing foil according to Claim 1, characterised in that either the release layer (4) or – when the structure of teh release layer is of several individual layers – the individual layer of the release layer nearest to the conductive layer, or a protective layer (3) lying between the conductive layer (1) and the release layer (4), contains soldering-facilitating flux.

7. Embossing foil according to Claim 1, characterised in that adhesion layer (2) and release layer (4) consist of different hot-melt adhesives, in that the transition point of the hot-melt adhesive for the release layer (4) lies below the transition point of the hot-melt adhesive used for the adhesion layer (2) and the solidification rate of the hot-melt adhesive for the release layer (4) is markedly smaller than that of the hot-melt adhesive used for the adhesion layer (2).

8. Embossing foil according to Claim 1, characterised in that the release layer (4) consists of substances which, upon reaching a certain temperatur which is clearly (for example 50°C) below the embossing temperature at which the application of the conducting tracks or of the electrical components onto the base is performed, transform chemically in such a way, sometimes with gas formation, that they lose their adhesive strength.

9. Embossing foil according to Claim 1, characterised in that the release layer (4) consists of an adhesive, the adhesive strength of which is raised or reduced by introducing a solvent in the embossing operation, and in that the solvent is introduced with the aid of microcapsules in such a way that the microcapsules which contain the solvent are mixed with the adhesive of the release layer (4) and liberate the solvent in the embossing operation.

10. Embossing foil according to Claim 1, characterised in that the release layer (4) consists of an adhesive, the adhesive strength of which is raised or reduced by chemical reaction with a reagent which is liberated in the embossing operation with the aid of microcapsules embedded in the release layer (4).

11. Embossing foil according to Claim 1 or 2, characterised in that the adhesion layer (2) consists of a substance which is converted into an adhesive by a solvent or a chemical reagent which is liberated in the embossing operation with the aid of microcapsules embedded in the adhesion layer (2).

12. Embossing foil according to Claim 1 or 2, characterised in that the adhesion layer (2) consists of a reagent – sometimes applied directly before the embossing operation onto the surface of the conductive layer – which enters a chemical bond with the surface of the base (6) and the surface of the conductive layer (1) during the embossing operation.

**Revendications**

1. Feuille d'impression pour l'application, par exemple, sur des supports isolants, de bandes conductrices et/ou d'éléments de composants électriques, qui est constitué au moins d'une couche adhésive, une couche conductrice de l'électricité, une couche de séparation et une bande porteuse, et avec laquelle sont imprimables, à l'aide d'une estampe, les bandes conductrices, par activation de la couche de séparation et de la couche adhésive, caractérisée en ce que la couche conductrice de l'électricité (1) est constituée par un matériau dont la résistance au cisaillement, en vertu de sa structure cristalline et de sa constitution, a une valeur assez faible pour que les bandes conductrices imprimées de même que les éléments électriques sont détachables de la partie non-imprimée de la couche conductrice (1) suivant une séparation à bords nets.

2. Feuille d'impression pour l'application, par exemple, sur des supports isolants, de bandes conductrices et/ou éléments de composants électriques, qui consiste en une couche conductrice de l'électricité et en une couche adhésive et avec laquelle les bandes conductrices sont imprimables par activation de la couche adhésive, caractérisée en ce que la couche conductrice de l'électricité, en tant que feuille auto-porteuse, est formée d'un matériau dont la résistance au cisaillement, en vertu de sa structure cristalline et de sa constitution, a une valeur assez faible pour que les bandes conductrices imprimées de même que les éléments électriques intégrés soient détachables de la partie non-imprimée de la couche conductrice suivant une séparation à bords nets.

3. Feuille d'impression selon la revendication 1 ou 2, caractérisée en ce que la conductibilité de la couche conductrice correspond à celle des bandes conductrices ou des circuits imprimés généralement connus (égale, par exemple pour le cuivre, à environ 50 m/ohm/mm²).

4. Feuille d'impression selon la revendication 1 ou 2, caracterisée en ce que la couche conductrice (1) présente une structure cristalline fibreuse ou fibrogranulaire perpendiculaire au plan de la couche.

5. Feuille d'impression selon la revendication 1 ou 2, caractérisé en ce que, pour modifier la résistance au cisaillement, des agents de dopage contenant du carbone, de l'azote et du soufre sont insérés dans la couche conductrice (1).

6. Feuille d'impression selon la revendication 1, caractérisée en ce que la couche de séparation (4) ou – dans le cas où la couche séparation est constituée de plusieurs couches séparées – la couche faisant partie la couche de séparation qui est la plus proche de la couche conductrice, ou bien une couche protectrice (3) située entre la couche conductrice (1) et la couche de séparation (4) contiennent un liquide facilitant le brassage.

7. Feuille d'impression selon la revendication 1, caractérisée en ce que la couche adhésive (2) et la couche de séparation (4) sont constituées de colles à fusion différentes, que le point de fixation de la colle à fusion pour la couche de séparation (4) est inférieur au point de fixation de la colle à fusion utilisée pour la couche adhésive (2) et que la vitesse de solidification de la colle à fusion utilisée pour la couche de séparation (4) est considérablement plus basse que celle de la colle à fusion utilisée pour la couche adhésive (2).

8. Feuille d'impression selon la revendication 1, caractérisée en ce que la couche de séparation (4) est constituée de substances qui, lorsqu'une température déterminée est atteinte, laquelle est nettement (par exemple de 50°C) inférieure à la température d'estampage à laquelle a lieu l'application des bandes conductrices ou des éléments électriques sur le support, se transforment chimiquement, éventuellement avec dégagement gazeux, de façon telle qu'elles perdent leur force d'adhérence.

9. Feuille d'impression selon la revendication 1, caractérisée en ce que la couche de séparation (4) est constituée d'une colle dont la force d'adhérence est annulée ou diminuée par l'introduction d'un solvant au cours du processus d'impression, et que le solvant est introduit à l'aide de microcapsules de telle manière, que les microcapsules qui contiennent le solvant sont mélangées à la colle de la couche de séparation (4) et libèrent le solvant lors du processus d'impression.

10. Feuille d'impression selon la revendication 1, caractérisée en ce que la couche de séparation (4) est constituée d'une colle dont la force d'adhérence est annulée ou diminuée par une réaction chimique avec un réactif qui est libéré lors du processus d'impression par l'intermédiaire de microcapsules incluses dans la couche de séparation (4).

11. Feuille d'impression selon la revendication 1 ou 2, caractérisée en ce que la couche adhésive (2) est constituée d'une substance qui se transforme en une colle sous l'action d'un solvant ou d'un réactif chimique qui sont libérés lors du processus d'impression par l'intermédiaire de microcapsules incluses dans la couche adhésive (2).

12. Feuille d'impression selon la revendication 1 ou 2, caractérisée en ce que la couche adhésive (2) est constituée d'un réactif – éventuellement déposé à la surface de la couche conductrice juste avant le processus d'impression – qui assure, pendant le processus d'impression, une jonction chimique entre la surface du support (6) et la surface de la couche conductrice (1).

FIG. 1

FIG. 2

FIG. 3

FIG.4

FIG.5